# EUROPEAN PATENT APPLICATION

(11) **EP 1 710 624 A2**
(43) Date of publication of application: **11.10.2006**
(21) Application number: 06003314.9
(22) Date of filing: 17.02.2006
(51) Int. Cl.: G03F 7/00, B81C 1/00

(54) **Methods of fabricating nano-scale and micro-scale mold for nano-imprint, and mold usage on nano-imprinting equipment**

(30) Priority: 06.04.2005 JP 2005109943
(71) Applicant: Hitachi, Ltd., Tokyo (JP)
(72) Inventor: Ohashi, Kenya, 1-chome, Chiyoda-ku, Tokyo 100-8220 (JP); Miyauchi, Akihiro, 1-chome, Chiyoda-ku, Tokyo 100-8220 (JP); Ogino, Masahiko, 1-chome, Chiyoda-ku, Tokyo 100-8220 (JP)
(74) Representative: Beetz & Partner

(57) **Abstract**

To provide a metal mold (101) excellent in the mold-release characteristic and the transfer accuracy in a nano-imprint method. By controlling the thickness of a metal oxide film (103) formed in the face of a release agent and a mold, the adhesive amount of the release agent layer formed in the outer layer thereof is adjusted, thereby forming a mold excellent in the mold-release characteristic. The present invention also relates to methods of fabricating molds for nano-imprint, and mold usage on nano-imprinting equipment.

## Description

### Field of the Invention

The present invention relates to a mold for nano-imprint wherein a fine structure is formed on a transferred substrate, which is made of resin, using a mold for forming nano meter level fine convexo-concaves, and to methods of fabricating the same, nano-imprinting equipment, and methods of nano-imprinting.

### Background of the invention

Recently, miniaturization and more integration of semiconductor integrated circuits have been progressing, and as a pattern transfer technique for realizing the fine process, higher precision of the photolithography equipment has been progressing. However, the processing method thereof has come near the wavelength of light sources in the light exposure, and the lithography technique has come near the limitations. Therefore, in order to advance the miniaturization and higher precision further, the electron beam lithography equipment, which is a type of charged particle beam equipment, is beginning to be employed instead of the lithography technique.

For the pattern formation using an electron beam, a method of drawing mask patterns, unlike a batch exposure method in the pattern formation using a light source, such as an i-line and an excimer laser, is adopted. Therefore, as the more patterns are drawn, the more exposure (drawing) time is taken, and that the pattern formation takes more time is a drawback. For this reason, as the degree of integration increases exponentially to 256 mega, 1 giga, 4 giga, and so on, the pattern formation time also will become longer exponentially accordingly, and a significant decrease of the throughput is a concern. Then, for the purpose of improvement in the speed of electron beam exposure equipment, the development of the batch pattern irradiation method, in which various shapes of masks are combined and an electron beam is irradiated to them altogether, thereby forming a complex shape of electron beams, has been progressing. As a result, while the miniaturization of patterns has been progressing, there is still a drawback in the increased cost of equipment because the size of the electron beam lithography equipment has to be increased, and a mechanism to control the mask position more accurately is needed, or the like.

On the other hand, a technique for forming fine patterns at low cost is disclosed in the following Patent Documents 1 and 2, non-Patent Document 1, or the like. In these techniques, a predetermined pattern is transferred by stamping a mold having the same pattern of convexo-concaves as the pattern, which is desired to be formed on a substrate, into a resist film layer formed in a transferred substrate face. According to the nano-imprint technique described in Patent Document 2 and non-Patent Document 1, in particular, a fine structure of 25 nm or less can be formed by transfer using a silicon wafer as the mold.
(Patent document 1) U.S. Pat. No. 5,259,926
(Patent document 2) U.S. Pat. No. 5,772,905
(Patent document 3) JP-A-2003-157520
(Non-Patent document 3) S. Y. Chou et al., Appl. Phys. Lett., vol. 67, p. 3114 (1995)

### Brief Summary of the Invention

However, when the present inventors investigated the above imprint techniques, which are assumed to be able to form fine patterns, it is found that in the case where Ni is used as the mold, there are problems in releasing the mold from a transferred object after the transfer, as follows. Namely, it was revealed that because the shape to transfer is extremely fine convexo-concave, unless a strong mechanical work is applied to the substrate and the mold (i.e. the transcripts) in the case where the transfer pattern is formed across a wide area, the both can not be separated to each other, and also a phenomenon that the residue of the resin remains on the mold side is observed.

In the above Patent Document 3, a technique is disclosed wherein a buffer layer, such as a polymer sheet and a rubber sheet made of a material softer than the mold and the press face, is provided in between the mold and the pressure face thereby to eliminate the waviness or the like of the substrate and providing a uniform pressure, and thus the mold-release characteristic is improved. However, when the present inventors conducted an experiment of transfer by using, as the buffer material, a material softer than the mold and the pressure face, even if the above material is resiliently deformed to fill the gap in between the mold and the pressure face during the pressuring, repulsion from the buffer material becomes consequently large in the portion with a narrow gap as compared with the portions with a wide gap, As a result, it was revealed that in-plane pressure irregularity was not eliminated and the mold-release characteristics was not improved, either.

In view of the above technical problems, it is an object of the present invention to enable the mold to be reused multiple times by mold-releasing a Ni metal and a transferred substrate without releasing them by means of a mechanical work, in the nano-imprint method, which is a pattern transfer technique of forming a structure with fine convexo-concave shapes.

According to a first aspect of the invention, there is provided a mold for nano-imprint, having a Ni-containing oxide film with a thickness of 1 to 3 nm on an imprint side surface of a mold, at least the imprint side surface of the mold being formed from Ni or Ni alloy.

Moreover, according to a second aspect of the invention, there is provided a method of fabricating a mold for nano-imprint, comprising the steps of: acid-treating a nano-imprint side surface having a surface formed from Ni or Ni alloy to form a Ni-containing oxide film with a thickness of 1 to 3 nm.

Moreover, according to a third aspect of the invention, there is provided an imprint equipment, comprising:
means for supporting a resin film in which nano meter level convexo-concaves are to be formed;
a mold for nano-imprint having a nano-imprint face; and
a stage which supports the mold for nano-imprint as to face to the resin film surface,
wherein at least the nano-imprint face of the mold for nano-imprint is formed from Ni or Ni alloy, and the nano-imprint face has a Ni-containing oxide film with a thickness of 1 to 3 nm and a water repellent resin film covering the surface thereof.

Moreover, according to a fourth aspect of the invention, there is provided a nano-imprint method, comprising the steps of:
bringing an imprint face of a mold made of Ni or Ni alloy, the mold having a Ni-containing oxide film with a thickness of 1 to 3 nm and a water-repellent resin film covering the surface thereof, in contact with an organic resin film face, in which nano meter level convexo-concaves are to be formed;
controlling a softening and hardening of the organic resin film with heat, light, and/or a carbon dioxide gas; and
transferring the convexo-concaves of the mold for nano-imprint onto the organic resin film face.

According to the invention, excellent nano-imprinting can be carried out without increasing the release force between the mold and the resin film, which is the transferred material, during nano-imprinting. Moreover, because the nano-imprint face is difficult to subject to damages, a long-life mold for nano-imprint is obtained.

Other objects, features and advantages of the invention will become apparent from the following description of the embodiments of the invention taken in conjunction with the accompanying drawings.

### Brief description of the Drawings

Fig. 1 is a schematic sectional view showing transfer in a mold for nano-imprint.
Fig. 2 is a sectional view showing a rough configuration of a nano-imprinting equipment of the invention.
Fig. 3 is a flow chart explaining a nano-imprint method of the invention.
Fig. 4 is a view showing a relationship between the thickness of a Ni-oxide film, and the contact angle of water.
Fig. 5 is a view showing a relationship between the thickness of a Ni-oxide film in a mold surface, in which a release agent layer is formed, and the contact angle of water.
Fig. 6 is a view showing a relationship between the thickness of a Ni-oxide film, and the thickness of a release agent layer formed thereabove.
Fig. 7 is a view showing a relationship between the thickness of a Ni-oxide film and the force required for releasing the resin on the transferred side.
Fig. 8 is a view showing a relationship of a force required for releasing the resin on the transferred side with respect to the sum of the thickness of a Ni-oxide film and the thickness of the release agent.
Fig. 9 is a schematic view of a biochip to which the invention is applied.
Fig. 10 is a bird's-eye view of the cross section of a filter portion in the biochip according to the embodiment of the invention.
Fig. 11 is a sectional view of a molecule filter in the biochip.
Fig. 12 is a flow chart showing steps of fabricating a multilayer interconnection substrate.
Fig. 13 shows a general view and an enlarged sectional view of a magnetic recording medium.
Fig. 14 is a flow chart showing steps of forming a pattern onto the recording medium by means of nano-imprint.
Fig. 15 is a plane view showing an outline configuration of an optical waveguide to which the invention is applied.
Fig. 16 is a view showing an outline layout of protrusions in the optical waveguide.

### (Description of Reference Numerals)

- 101: -- Ni mold
- 102: -- Mold substrate
- 103: -- Oxide film
- 104: -- Release agent
- 10: -- Dust-free transfer chamber
- 11: -- Buffer sheet
- 12: -- Cooling pipe
- 13: -- Dielectric coil
- 14: -- Stage
- 15: -- Transferred substrate
- 16: -- Mold made of Ni
- 17: -- head
- 900: -- Biochip
- 901: -- Substrate
- 902: -- Passage
- 903: -- Lead-in hole
- 904: -- Discharge orifice
- 905: -- Molecule filter
- 100: -- Protrusion assembly
- 1001: -- Upper substrate
- 1002: -- Silicon oxide film
- 1003: -- Copper wiring
- 1006: -- Multilayer interconnection substrate
- 702: -- Resist
- 703: -- Exposed region
- 1004: -- Metal plating film
- 1005: -- Metal film formed by sputtering
- 500: -- Optical circuit
- 501: -- Substrate
- 502: -- Transmitter unit
- 503: -- Optical waveguide
- 504: -- Optical connector
- 406: -- Protrusion

### Detailed Description of the Invention

The present inventors believed that because in case of a Ni mold among metal molds, a Ni-oxide film is present in the surface of the mold, and a release agent tends not to be formed in layers in the mold face due to the crystal properties of the oxide, inconvenience will arise in the mold release after the transfer. Moreover, the present inventors believed the adhesive properties of the release agent are improved by adjusting the thickness of the oxide film, which led us to the present invention.

That is, the present invention is an invention of a mold for nano-imprint made of Ni or Ni alloy. The present invention is applied to a mold wherein the mold and a transferred substrate are pressurized uniformly when transferring fine convexo-concaves of the surface of the mold, the mold having the fine convexo-concaves formed in the surface thereof, onto the surface of the transferred substrate by pressure using a pressure device. The above mold has a Ni-containing oxide film on the imprint side face, and by controlling the thickness thereof within a certain range, the release of the mold (in which a resin film as the release material is formed in the imprint face thereof) from the transferred resin film during nano-imprinting can be carried out with a small force. Accordingly, there are also few damages to the mold, the mold will be long-lived, and moreover, the transcripts have few distortions and positional deviations, thus obtaining highly precise nano-imprint. Moreover, because the release force is very small, means for releasing the mold from the transferred resin film may be omitted.

According to the present invention, in the method of transferring a fine pattern, in which method a mold, in which fine convexo-concaves are formed, is stamped to a transferred substrate with the use of the pressure device thereby to transfer the fine convexo-concave pattern in the surface of the mold onto the transferred substrate, the mold, in which the fine convexo-concaves are formed, of the pressure device is formed from a Ni-containing oxide film and a release agent. The invention relates to the method of transferring a fine pattern, in which method pressurizing is carried out using the mold in which the thickness of this oxide film is controlled.

Hereinafter, more specific embodiments of the invention will be exemplified. The contact angle of the surface of a Ni-containing oxide film against water is preferably 100 degrees or more. It is preferable that a resin film for mold release be prepared on the surface of the Ni-containing oxide film. Although the thickness of the resin film as the release material is optional, it is desirably 200 nm or less. The lower limit of the thickness may be a thickness at a level of protecting the nano-imprint face from influences of the open air and at a level of not being worn out by the pressure during nano-imprinting. For example, it just needs to be 2 nm or more. It is preferable that the contact angle between the resin film and water be 100 degrees or more.

It is preferable that the nano-imprint side surface of the mold be terminated with oxygen and a hydroxyl group. Although when Ni is oxidized in the atmosphere, NiO is usually formed, Ni (OH)₂ may be formed through a reaction with water (water vapor) in the atmosphere, thereby becoming the top surface. Moreover, it is preferable that the mold surface be covered with a resin film after being terminated with oxygen and a hydroxyl group. The contact angle between the resin film and water is preferably 100 degrees or more.

Here, it is preferable that Ni, Ni alloy, or Ni plating be used as the metal mold. Namely, this is because in atmospheric environment it is difficult to maintain a fine pattern shape with metal of which surface shape changes by corrosive action. Moreover, while the oxide film becomes a NiO crystal as a natural oxide film, it may become in an amorphous state where the crystal form is generally obscure, or otherwise may become a compound of which top surface layer is replaced by a hydroxyl group. Moreover, it is preferable that the release agent formed in the surface be a fluorine compound or a heat-resistant resin made of a fluorine mixture. In particular, an organic resin known as the water repellent material with the contact angle against water of 100 degrees or more is preferable.

It is preferable that metal used for the mold of the invention have a high thermal conductivity in order to transfer energy from the heating element to the mold and the transferred substrate efficiently. Moreover, it is preferable that the thermal deformation amount of the mold of the invention be small at temperatures below the glass-transition temperature of the transferred substrate. With the use of such a metal, almost no oxidization effect due to corrosion is observed at room temperature, the storage and handling become easy, and highly precise transfer can be secured taking advantage of the thermal conductivity during the heat transfer.

Here, the method of molding a transferred substrate to be used in the invention is preferably selected from (1) A method of heating a resin substrate or a resin film on a substrate thereby to deform, or (2) A method of photo-curing after pressure-forming a resin substrate or a resin film on a substrate.

A pressure device to be used in the invention comprises a press stage and a press head having two press faces at upper and lower portions for pressuring the mold and the transferred substrate altogether, and a pressure thrust generation mechanism to apply pressure to them. Here, it is preferable that the press head and the press stage include an induction coil for inductive heating the mold, and a cooling mechanism for cooling the mold and the transferred substrate. Moreover, the pressure thrust generation mechanism generates a thrust using an oil pressure force, an air pressure force, an electric force by a torque motor, or the like. Furthermore, a vacuum chamber may be included that enables the transfer under vacuum conditions by decompressing the whole of the press stage and press head, as required.

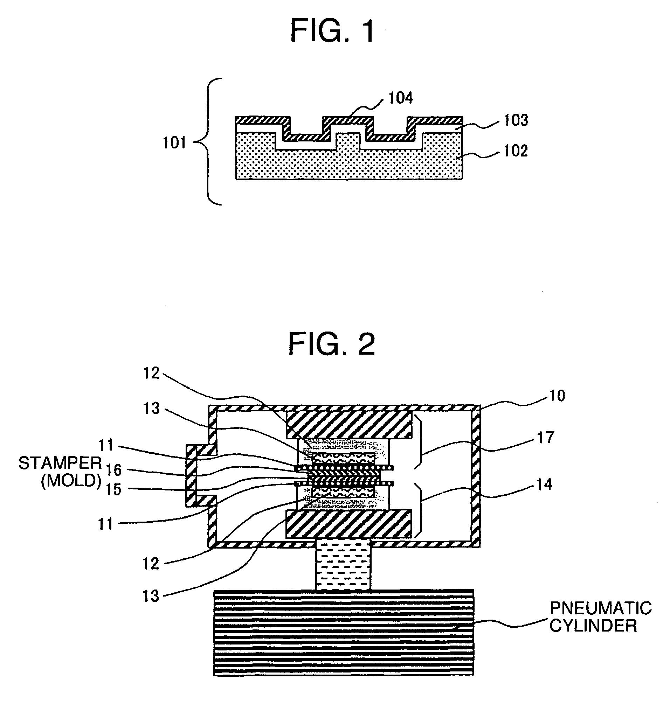

A mold for nano-imprint of the invention and a method of nano-imprinting will be described with reference to Fig. 1 and Fig. 2. First, as for the mold, a silicon substrate or the like is used, but among metal, Ni excellent in corrosion resistance is often used. A mold (101) having a fine pattern on the surface thereof is produced. This includes a metal mold substrate (102) and an oxide film (103) that is spontaneously formed in the outer surface thereof in the atmosphere, or otherwise that is formed adjusting the ambient temperature. Moreover, a release agent layer (104) is formed in the surface of the oxide film (103) of the mold, in which convexo-concave shapes are formed. With the use of this mold, fine convexo-concave shapes are transferred onto the substrate coated with resin.

In Fig. 2, a nano-imprinting equipment, which is a transfer equipment with a dust-freed transfer chamber, is shown. In a dust-free transfer chamber 10, a buffer sheet 11 is stuck, with the use of a pressure device, to a stage 14, in which a cooling pipe 12 and a dielectric coil are incorporated, and onto a silicon wafer of 6 inch Φ. Moreover, the buffer sheet 11 is arranged in between the stage 14 and a transferred substrates 15, in which a polystyrene thin film with a thickness of 0.5 µm is formed, and in between a head 17, in which the cooling pipe 12 and the dielectric coil 13 are incorporated like the stage 14, and a Ni made mold 16 of 6 inch Φ produced by the above-described method. In this way, nano-imprint in this equipment becomes possible.

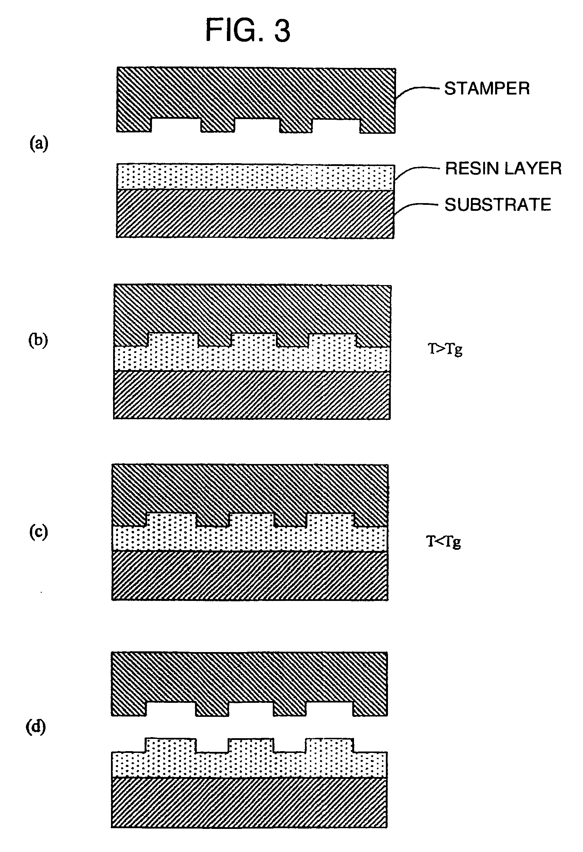

The nano-imprint method will be described with reference to Fig. 3. A mold (stamper) having a fine pattern on the surface of Ni or the like is produced. A resin film is provided on another substrate different from this (Fig. 3 (a)). A buffer sheet (not shown) is arranged in the back face of the mold, and the mold is pressed onto the resin film under a predetermined pressure at temperatures above the glass-transition temperature (Tg) of this resin using a pressure device (Fig. 3 (b)).

Next, the mold and the resin are cooled and cured (Fig. 3 (c)). The mold and the substrate are released to each other and a fine pattern of the mold is transferred onto the resin film on the substrate (Fig. 3 (d)). Moreover, in place of the step of heat-molding, a photocurable resin may be used and, after the molding, light, usually ultra violet light, may be irradiated to the resin to cure the resin.

The nano-imprint method has features such as (1) An extremely fine integrated pattern can be transferred efficiently, (2) Equipment cost is low, and (3) Complex shapes can be accommodated and pillar formation or the like are also possible.

The application field of the nano-imprint method of the invention, taking advantage of these features, extensively includes (1) Various biotechnology devices, such as a DNA chip and an immunity analysis chip, especially a disposable DNA chip, or the like, (2) Semiconductor multilayer interconnection, (3) Printed circuit boards and RF MEMS, (4) Optical or magnetic storage, (5) Optical devices, such as a waveguide, a diffraction grating, a micro lens, and a polarization element, and a photonic crystal, (6) Sheets, (7) LCD display, (8) FED display, or the like. The present invention is preferably applied to these fields.

In the invention, the nano-imprint refers to transfer in the range from approximately several hundreds µm to several nm. In the invention, the mold for nano-imprint refers to the one having a fine pattern to be transferred, and the method of forming this pattern onto the mold for nano-imprint is not limited in particular. For example, a photolithography, an electron beam lithography method, or the like are selected according to the desired processing accuracy.

In the invention, although the material to be a substrate is not limited in particular, it may be the one having a predetermined strength. Specifically, silicon, various metal materials, glass, ceramics, plastics, or the like are preferably exemplified.

In the invention, although the resin film to which a fine structure is transferred is not limited in particular, it is selected according to the desired processing accuracy. Specifically, there are listed thermoplastic resins, such as polyethylene, polypropylene, polyvinyl alcohol, polyvinylidene chloride, polyethylene terephthalate, polyvinyl chloride, polystyrene, ABS resin, AS resin, acrylic resin, polyamide, polyacetal, poly butylene terephthalate, glass reinforced polyethylene terephthalate, polycarbonate, modified polyphenylene ether, polyphenylene sulfide, polyether ether ketone, mesomorphism polymer, fluororesin, poly allate, poly sulfone, polyether sulfone, polyamide imide, polyether imide, and thermoplastic polyimide. Moreover, there are also listed thermosetting resins, such as phenol resin, melamine resin, urea resin, epoxy resin, unsaturated polyester resin, alkyd resin, silicone resin, diallyl phthalate resin, polyamide bismaleimide, and polybisamide triazole. Furthermore, materials made by blending two or more kinds of these may be used.

### EXAMPLE

Hereinafter, the examples of the invention will be described.

### [Example 1]

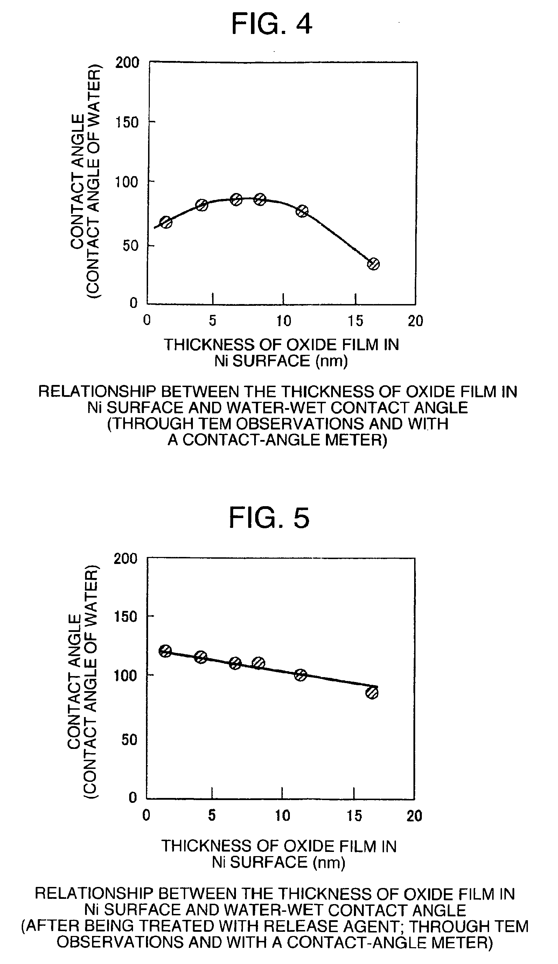

The characteristic of the surface oxide-film of a Ni mold, which is one of the embodiments of the invention, will be described using Fig. 4 and Fig. 5. In the Ni mold, just before applying a release agent, an oxide film formed by natural oxidation or an oxide film formed by an oxidation treatment, the oxide film being present in the surface, is treated with acid cleaning. In the case where a hydrochloric acid is used as the acid-cleaning chemical, a solution of 0.5 - 10% by weight concentration is preferable, and a solution of 1 - 5% by weight concentration is preferable in particular. In the case where a sulfuric acid is used as the acid-cleaning chemical, a solution of 0.5 - 3 % by weight concentration is preferable, and a solution of 0.5 - 2% by weight concentration is preferable in particular. Preferably, the temperature for the acid cleaning is 20 - 27°C, and the acid-cleaning time is 20 - 50 sec. Because these conditions vary depending on the quality of materials of the mold to be used, the optimum condition is chosen accordingly.

Fig. 4 and Fig. 5 are the measurement results of the contact angle of water in the Ni surface. These data were obtained through cross-section observation of the metal surface by a transmission electron microscope (TEM), and through the measurement by a contact-angle meter. Generally, the larger the contact angle is, the higher the mold-release characteristic is, and the more suitable the mold surface is.

Fig. 4 shows variations of the water contact angle against the oxide-film thickness on the Ni surface. It was found that the contact angle is large in the range of 5 nm to 10 nm of the Ni surface oxide film, and that in the Ni surface untreated with release agent, the mold-release characteristic improves in the range of 5 nm to 10 nm of the Ni-oxide film as compared with the Ni metal surface. However, because the contact angle thereof is 90 degrees or less, the thick Ni-oxide film is not the excellent release agent.

Fig. 5 shows the variations of water contact angle in the case where the release agent is formed on the oxide film in the Ni surface. The data of Fig. 5 was obtained through TEM observation and contact-angle measurements after the mold release treatment. The thickness of the release agent layer in this embodiment is 2-4 nm.

It was found that as the Ni surface oxide film to serve as the substrate becomes thinner, the contact angle becomes larger, and that in the Ni surface treated with the release agent, the mold-release characteristic improves remarkably if the Ni-oxide film is 5 nm thick or less. Because the contact angle is 100 degrees or more, it is an excellent release agent.

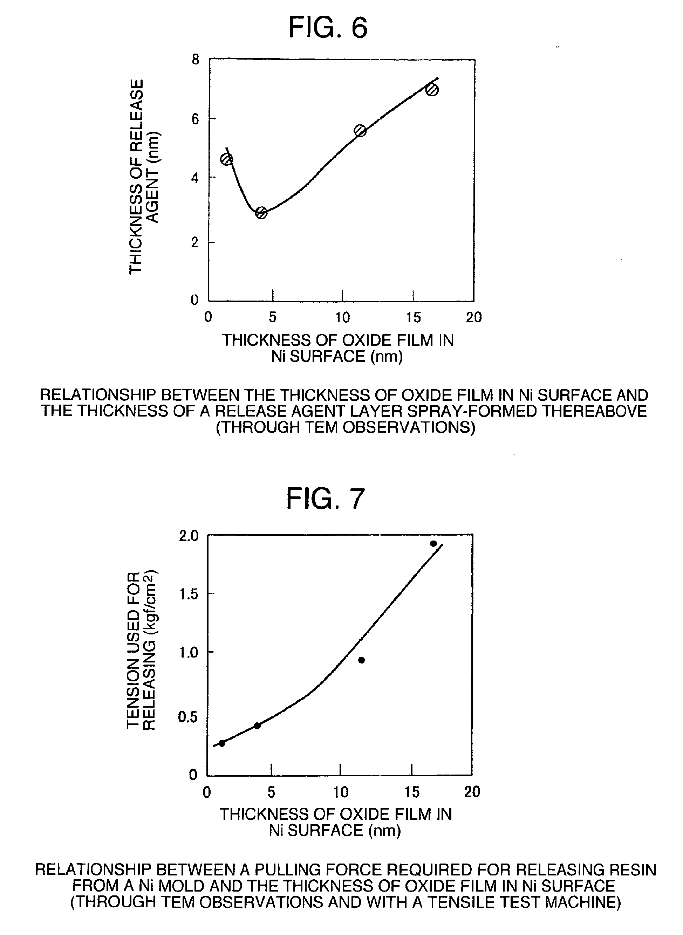

Fig. 6 shows a relationship of the thickness between the Ni-oxide film and the release agent. The data of Fig. 6 was obtained through TEM observations of the cross-section. The thickness of the release agent becomes a minimum at around 3 nm of the Ni-oxide film thickness. As the Ni-oxide film thickness increases further, the release agent thickness will also increase. However, it turned out that this release agent adheres to the oxide film of which surface roughness is increased, which is an island-like adhesion in which two-dimensional continuity in the flat surface is reduced, and that the release force to be described later has been increased.

Next, the transfer experiment using the mold of the invention was carried. Hereinafter, a method of fabricating a mold, in which fine convexo-concaves are formed, to be used in this transfer will be described using Fig. 6. A Si wafer 7 of 6 inch Φ x approximately 0.5 mm thickness was prepared. Next, a 0.5 µm film was formed using a spin coater with the use of the resist 8 (OEBR 1000 manufactured by Tokyo Ohka Kogyo Co., Ltd.) used for electron beam lithography. Subsequently, it is exposed direct-writing with an electron beam 9 with the use of the electron beam lithography equipment JBX6000FS (manufactured by JEOL. Ltd.), and is developed to form the convexo-concaves. The resist is left so that a circular pattern with a diameter of 100 nm is located in a matrix shape at a pitch of 150 nm. In addition, if the pattern is a size of several hundreds nm order or more, a Kr laser (with a wavelength of 351 nm) or the like may be used in place of the electron beam. Dry etching of Ni metal was carried out using the convexo-concaves as the mask pattern to form convexo-concaves in the Ni surface, and thereafter the resist is removed with O₂ ashing. Through the above steps, a mold made of Ni in which cylindrical protrusions with a diameter of 100 nm are formed across the surface was obtained.

Next, the mold of the invention is stacked, by means of the pressure device, onto the stage, and the transferred substrate, in which a polystyrene thin film with a thickness of 0.5 µm is formed on a silicon wafer of 6 inch Φ, thereby conducting the transfer experiment. The transfer conditions were at the transfer temperature of 200°C, under the pressure of 10 kgf/cm², and for the holding-time of 3 minutes. During the transfer, the measurements of heat-up time from 60°C to 200°C, and of cool down time from 200°C to 60°C, and also the in-plane pattern formation were evaluated. As a result, the heat-up time and the cool down time were one minute or less. Moreover, the in-plane variation of the transfer pattern was not observed, and transfer irregularities did not occur across the 6 inch Φ, and an excellent transfer pattern was obtained. On the background that the uniform transfer was achieved, there is a fact that the whole transfer substrate could be released from the mold without receiving external force actions thanks to the invention. The principle of this is considered to be based on a fact that the adhesive strength (the physical force (van der Waals force) and the chemical force (ionic bonding force) between the resin and the mold) produced between the substrate and the mold is reduced by using the oxide-film layer and the release agent layer of the invention. As a result, the mold release was uniformly realized across the whole surface.

### [Example 2]

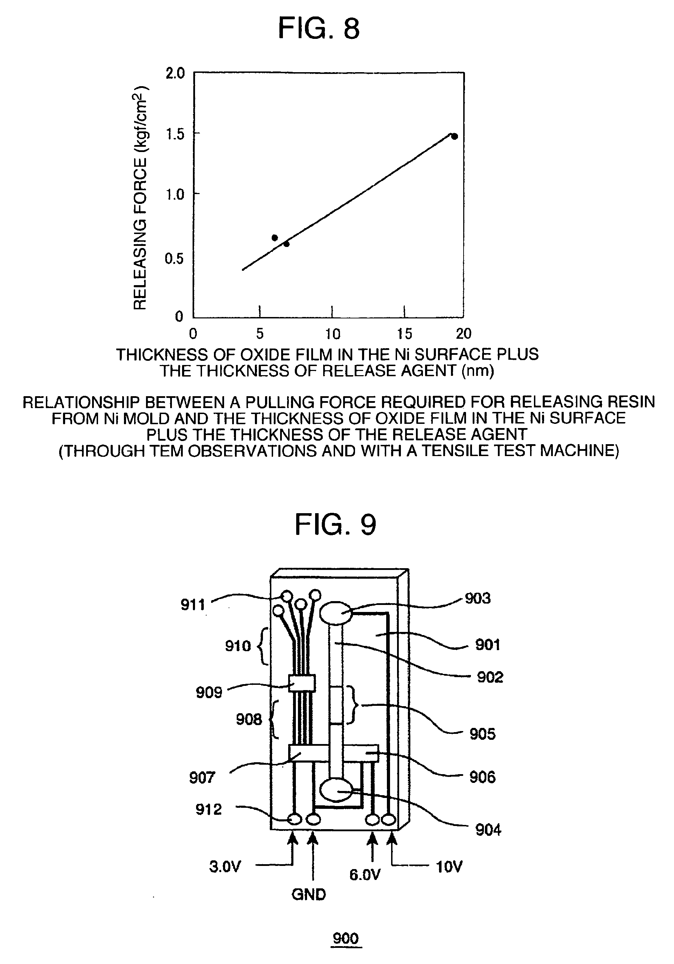

The force required for the release between the mold and the transferred substrate, which is one of the embodiments of the invention, will be described using Fig. 7 and 8. The mold was produced using the same method as that of the embodiment 1, and the force required for the mold-release of the mold and the substrate was measured with a tensile test machine. Fig. 7 shows the force required during the mold release against the Ni-oxide film thickness in the mold surface. It was found that as the thickness of a Ni-oxide film becomes thinner, it can be released with a lower force. Fig. 8 shows the force required during the mold release against the sum of the thickness of the Ni-oxide film in the mold surface, and the thickness of the release agent. The data of Fig. 7 and Fig. 8 were obtained through observations by TEM, and the measurements by the tensile test machine. It turned out that as the sum of the thickness of the Ni-oxide film and the thickness of a mold-release agent becomes thinner, it can be released with a lower force. It was also found that because the release force is small in the case where the thickness of a Ni-oxide film is 3 nm or less, the resin remaining in the mold is reduced and thus the mold can be reused repeatedly.

Hereinafter, several fields, to which the nano-imprint using the mold with the release mechanism of the invention is preferably applied, will be described.

### [Example 3: Biotechnology (immunity) chip]

The invention is applied to a mold used for biochip preparation. Fig. 9 is a schematic view of a biochip 900. The biochip 900 has a structure wherein a passage 902 with a depth of 3 um and a width of 20 um is formed in a glass substrate 901, and a sample containing DNA (deoxyribonucleic acid), blood, protein, or the like is introduced from a lead-in hole 903, and flown through the passage 902, and then flown to a discharge orifice 904. A molecule filter 905 is installed in the passage 902. A protrusion assembly 100 with a diameter of 250 nm to 300 nm and a height of 3 um is formed in the molecule filter 905.

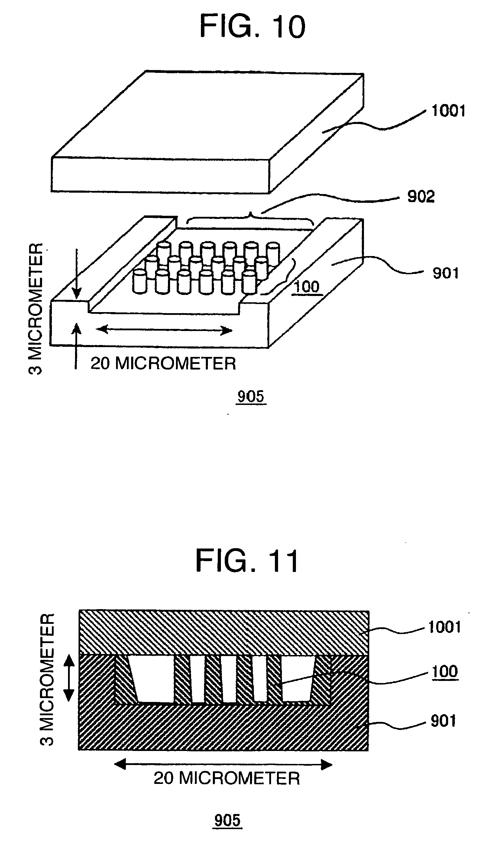

Fig. 10 is a cross-sectional bird's-eye view around a portion in which the molecule filter 905 is formed. The passage 902 is formed in the substrate 901, and the protrusion assembly 100 is formed in part of the passage 902. The substrate 901 is covered with an upper substrate 1001, and the sample will move inside the passage 902. For example, in case of analysis on DNA chain length, DNA is separated with high resolution by the molecule filter 905 according to the DNA chain length when the sample containing DNA electrophoreses through the passage 902. A laser beam from a semiconductor laser 906 mounted in the surface of the substrate 901 is irradiated to the sample which passed through the molecule filter 905.

Because the incident light onto a light sensitive detector 907 decreases by approximately 4 % when the DNA passes therethrough, the DNA chain length in the sample can be analyzed by the output signal from the light sensitive detector 907. The signal detected at the light sensitive detector 907 is inputted to a signal processing chip 909 via a signal wiring 908. Signal wiring 910 is coupled with the signal-processing chip 909, and the signal wiring 910 is coupled with an output pad 911 and connected to a terminal from the outside. In addition, the electric power was supplied to each part from a power supply pad 912 installed in the surface of the substrate 901.

A sectional view of the molecule filter 905 is shown in Fig. 11. The molecule filter 905 of this embodiment is composed of the substrate 901 having a recess, a plurality of protrusions formed in the recess of the substrate 901, and the upper substrate 1001 formed as to cover the recess of the substrate. Here, the tip of the protrusion is formed as to come in contact with the upper substrate. Because the principal component of the protrusion assembly 100 is an organic substance, it can be deformed and thus in covering the upper substrate 1001 onto the passage 902, the protrusion assembly 100 will not be damaged.

Accordingly, it is possible to closely contact the upper substrate 1001 to the protrusion assembly 100. With such a configuration, the sample will not leak out of the gap between the protrusions and the upper substrate 1001, allowing a highly sensitivity analysis to be made. As a result of the actual analysis on the DNA chain length, it was found that while the resolution of a base pair was 10 base pairs in full-width at half maximum in the protrusion assembly 100 made of glass, the resolution of the base pair can be improved to 3 base pairs in full-width at half maximum in the protrusion assembly 100 made of an organic substance. In the molecule filter of this embodiment, a structure is formed in which the protrusion comes in directly contact with the upper substrate, however, for example, if a structure is formed in which a film made of the same material as the protrusion is formed in the upper substrate, and the protrusion comes in contact with this film, then the adhesion can be improved.

In addition, although in this embodiment the count of the passage 902 was one, it is also possible to carry out different analysis simultaneously by arranging a plurality of passages 902 in which the protrusions with different sizes are installed. Moreover, although in this embodiment DNA was investigated as the sample, a specific oligosaccharide, protein, and antigen may be analyzed by modifying the surface of the protrusion assembly 100 with a molecule in advance, which reacts with oligosaccharide, protein, and antigen. In this way, by modifying the surface of the protrusions with antibody, the sensitivity of immunity analysis can be improved.

By applying the invention to biochips, it is possible to obtain an effect that the protrusions used for the analysis on an organic material with a nano scale diameter can be formed easily. Moreover, it is also possible to obtain an effect that the position, diameter, and height of the protrusions made of an organic material can be controlled by controlling the convexo-concaves in the surface of the mold and the viscosity of the thin film of organic material. Microchips used for highly sensitive analysis can be provided.

### [Example 4: Multilayer interconnection substrate]

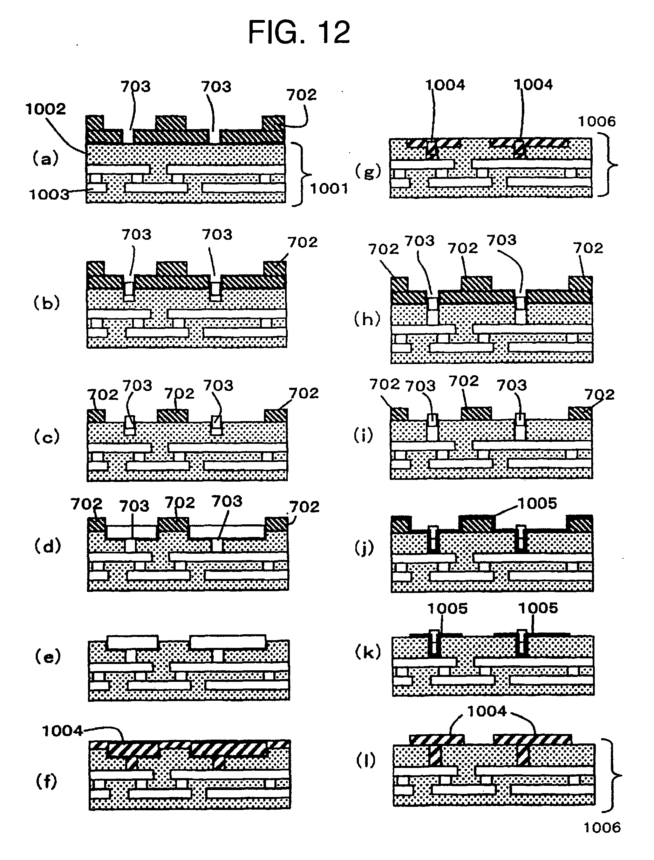

A Ni mold of the invention can be applied to nano-imprint for producing a multilayer interconnection substrate (1006). Fig. 12 is a view explaining the steps for producing the multilayer interconnection substrate. First, as shown in Fig. 12 (a), after forming a resist 702 in the surface of a multilayer interconnection substrate 1001 composed of a silicon oxide 1002 and a copper wiring 1003, pattern transfer by a mold (not shown) is carried out. Next, dry-etching the exposed region 703 of the multilayer interconnection substrate 1001 with a CF4/H2 gas, the exposed region 703 in the surface of the multilayer interconnection substrate 1001 is processed into a groove shape, as shown in Fig. 12 (b). Next, by resist-etching the resist 702 with RIE to remove the resist in portions with a lower step, the exposed region 703 is enlarged to be formed as shown in Fig. 12 (c). By dry etching the exposed region 703 from this state until the depth of the groove formed earlier reaches the copper wiring 1003, a structure shown in Fig. 12 (d) is obtained, and then, the resist 702 is removed, thereby obtaining the multilayer interconnection substrate 1001 having a groove shape in the surface, like the one shown in Fig. 12 (e). From this state, a metal film is formed in the surface of the multilayer interconnection substrate 1001 by sputtering (not shown), and thereafter electrolysis plating is carried out to form a metal plating film 1004, as shown in Fig. 12 (f). Then, by polishing the metal plating film 1004 until the silicon oxide 1002 of the multilayer interconnection substrate 1001 is exposed, the multilayer interconnection substrate 1001 having a metal wiring in the surface can be obtained, as shown in Fig. 12 (g).

Moreover, other steps for producing the multilayer interconnection substrate will be described. In dry etching the exposed region 703 from the state shown in Fig. 12 (a), the etching is carried out until it reaches the copper wiring 1003 in the multilayer interconnection substrate 1001, whereby a structure shown in Fig. 12 (h) is obtained. Next, the resist 702 is etched by RIE to remove the resist in portions with a lower step, whereby a structure shown in Fig. 12 (i) is obtained. From this state, forming a metal film 1005 in the surface of the multilayer interconnection substrate 1001 by sputtering, a structure of Fig. 12 (j) is obtained. Next, the resist 702 is removed by lift-off, thereby obtaining a structure shown in Fig. 12 (k). Next, by carrying out electroless plating using the remaining metal film 1005, the multilayer interconnection substrate 1001 of a structure shown in Fig. 12 (1) can be obtained.

By applying the invention to multilayer interconnection substrates, it is possible to form wiring with high dimensional accuracy. According to the embodiment of the invention, in transferring a fine convexo-concave pattern onto resin on a substrate or onto resin by means of nano-imprint using a metal mold, especially a Ni mold, the mold release failure after the transfer can be eliminated by using a mold, in which the transfer surface of a Ni metal mold is composed of a thin oxide film and a release agent. Moreover, thermal conductivity to the mold surface can be improved due to an effect of thinning the thickness of the oxide film. The means for releasing may not be provided, and thus the heat conduction can be improved. Thereby, time required for the transfer can be reduced and the repetitive usage of the mold is allowed, and moreover, the durability of the mold can be improved due to the hardness given by the oxide film.

### [Example 5: Magnetic disk]

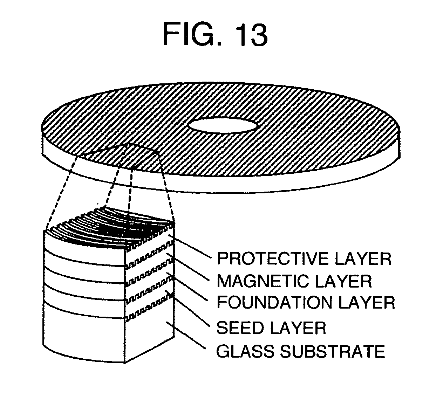

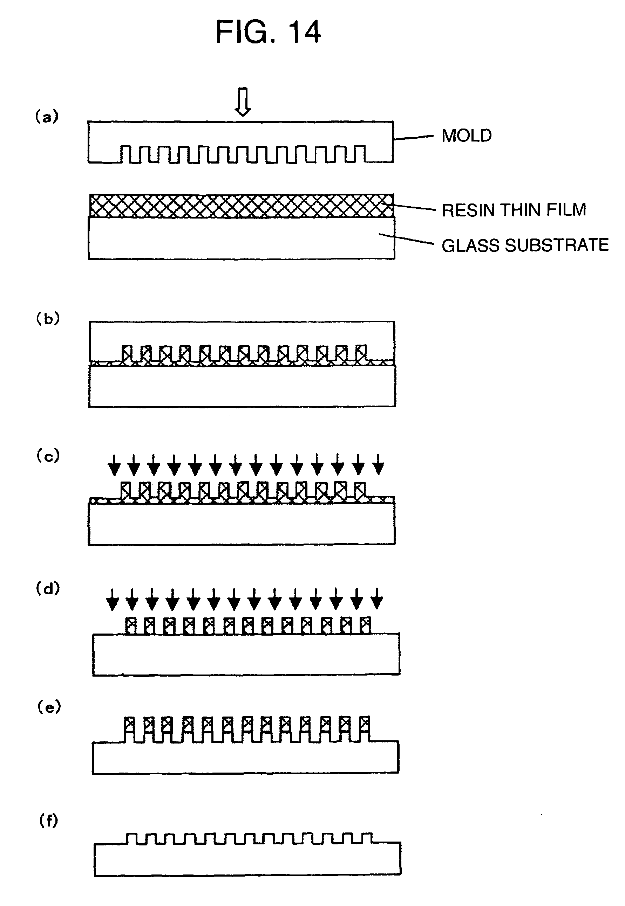

Production of a magnetic recording medium by means of nano-imprint using the Ni mold according to this embodiment is possible. Fig. 13 shows a general view and an enlarged cross-section view of a magnetic recording medium of this embodiment. The substrate is made of glass having fine convexo-concaves. A seed layer, a foundation layer, a magnetic layer, and a protective layer are formed on top of the substrate. Hereinafter, a method of manufacturing the magnetic recording medium of this embodiment will be described using Fig. 14. In Fig. 14, a method of forming convexo-concaves onto the glass by means of the nano-imprint method is shown using sectional views cut in the radial direction. A glass substrate is prepared first. Soda-lime glass was used in this embodiment. The material of the substrate is not limited in particular as long as it has flatness, other glass substrate material, such as an aluminosilicate glass, or a metal substrate such as Al may be used. Then, as shown in Fig. 14 (a), a resin film was formed as to be 200 nm thick using a spin coater. Here, PMMA (polymethyl methacrylate) was used as the resin.

On the other hand, as the mold, a Ni mold is prepared in which a groove is formed as to be concentric with respect to a hole in the center of the magnetic recording medium. Dimensions of the groove are 88 nm wide, and 200 nm deep, and the distance between the grooves was set to 110 nm. Because the convexo-concaves of the mold are very fine, they were formed by photolithography using an electron beam. Next, as shown in Fig. 14 (b), after heating up the mold to 250°C and decreasing the resin viscosity, the mold is pressed. Releasing the mold at temperatures below the glass-transition point of the resin, a pattern like Fig. 14 (c), in which the mold and the convexo-concaves are reversed, is obtained. Using the nano-imprint method this way, a fine pattern formation, of which pattern is smaller than the visible light wavelength and is beyond the exposable dimensional limitations in the general optical lithography, is possible.

Moreover, by removing the residual film that remained in the bottom of the resin pattern with dry etching, a pattern like Fig. 14 (d) is formed. By further etching the substrate with a hydrofluoric acid using this resin film as the mask, the substrate can be processed like Fig. 14 (e), and then by removing the resin with a release liquid, grooves with a width of 110 nm, and a depth of 150 nm, like Fig. 14 (f), are formed. Then, a seed layer made of NiP is formed on the glass substrate by electroless plating. In general magnetic disks, a NiP layer is formed in the thickness of 10 µm or more, however, in this embodiment it was set up to 100 nm so as to reflect the fine convexo-concave shape formed in the glass substrate onto the upper layer, as well. Furthermore, by successively film-forming a Cr foundation layer of 15 nm, a CoCrPt magnetism layer of 14 nm, and a C protective layer of 10 nm with the use of a sputtering method that is generally used for the magnetic recording medium formation, the magnetic recording medium of this embodiment was produced. In the magnetic recording medium of this embodiment, the magnetic substance is isolated in the radial direction by a non-magnetic layer wall with a width of 88 nm. Accordingly, the in-plane magnetic anisotropy could be increased. In addition, while the concentric pattern formation (texturing) using a polishing tape is conventionally known, the distance between patterns is as large as a micron scale, so the concentric pattern formation is difficult to be applied to the high-density recording medium.

In the magnetic recording medium of this embodiment, the magnetic anisotropy is secured with the fine pattern using the nano-imprint method, and a high-density record as large as 400 Gb/square inch could be realized. In addition, the pattern formation by the nano-imprint is not limited to the circumferential direction, but a non-magnetic bulkhead can be formed in the radial direction. Furthermore, the magnetic-anisotropy effect described in this embodiment is not particularly limited according to the material of the seed layer, substrate layer, magnetic layer, and protective layer.

### [Example 6: Optical-waveguide]

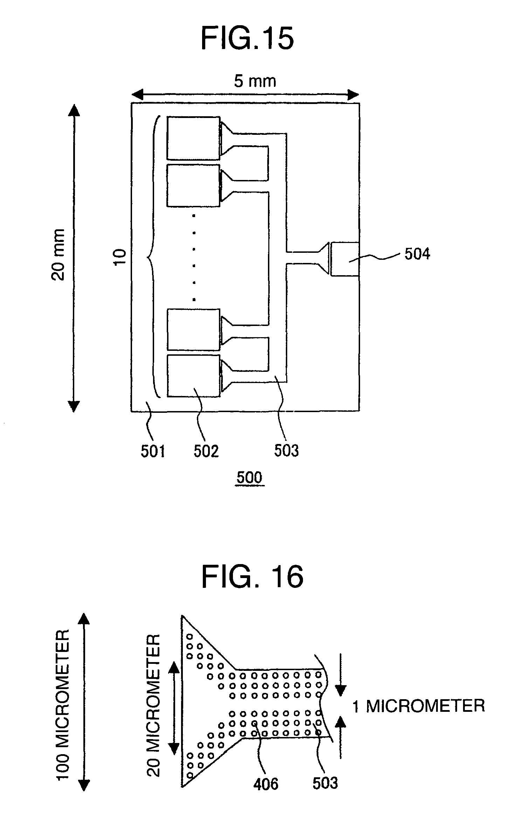

In this embodiment, an example will be described in which an optical device, in which the traveling direction of an incident light is changed, is applied to an optical information processing equipment. Fig. 15 is a schematic block diagram of the produced optical circuit 500. An optical circuit 500 comprises: ten transmitting units 502 composed of a semiconductor laser of an indium phosphorus system and a driver circuit; an optical waveguide 503; and an optical connector 504 on an aluminum nitride substrate 501 with a length of 30 mm, a width of 5 mm, and a thickness of 1 mm. In addition, the transmitting wavelengths of the ten semiconductor lasers each differ by 50 nm, and the optical circuit 500 is a principal part of the devices in the optical multiplex communication system.

Fig. 16 is a schematic layout view of protrusions 406 in the optical waveguide 503. The end of the optical waveguide 503 is formed into the shape of a trumpet with a width of 20 um so that the alignment error between the transmitting unit 502 and the optical waveguide 503 can be allowed, and it has a structure in wherein a signal light is led into a region with a width of 1 um by photonic band gap. In addition, the protrusions 406 were disposed at an interval of 0.5 um, however, in Fig. 16, for simplification, the protrusions 406 few than the actual count are illustrated.

In the optical circuit 500, signal lights of ten different kinds of wavelengths can be superimposed to be outputted, and because the traveling directions of the lights can be changed, the width of the optical circuit 500 can be made very narrow to 5 mm, providing an effect of enabling the optical communication to be miniaturized. Moreover, because the protrusions 406 can be formed by pressing the mold, an effect of reducing the manufacturing cost is also obtained. Although in this embodiment the device in which the input lights are superimposed has been described, it is apparent that the optical waveguide 503 is useful for all the optical devices that control the traveling course of light.

By applying the invention to the optical waveguide, an effect that the traveling directions of light can be changed by forcing the signal light to travel through the structure, in which the protrusions made of an organic substance as the principal component are disposed periodically, is obtained. Moreover, since the protrusions can be formed by a simple manufacturing technology of pressing a mold, an effect that the optical devices can be manufactured at low cost is obtained.

It should be further understood by those skilled in the art that although the foregoing description has been made on embodiments of the invention, the invention is not limited thereto and various changes and modifications may be made without departing from the spirit of the invention and the scope of the appended claims.

## Claims

1. A mold (101) for nano-imprint, having a Ni-containing oxide film (103) with a thickness of 1 to 3 nm on an imprint side surface of the mold, at least the imprint side surface of the mold being formed from Ni or Ni alloy.

2. The mold (101) for nano-imprint according to claim 1, wherein a contact angle between the surface of the Ni-containing oxide film (103) and water is 100 degrees or more.

3. The mold (101) for nano-imprint according to claim 1 or 2, further having a resin film for mold release (104) on the surface of the Ni-containing oxide film (103).

4. The mold (101) for nano-imprint according to claim 3,wherein a contact angle between the resin film and water is 100 degrees or more.

5. The mold (101) for nano-imprint according to any of claims 1 to 4, wherein the nano-imprint side surface of the mold is terminated with oxygen and a hydroxyl group.

6. The mold (101) for nano-imprint according to claim 5, wherein the nano-imprint side surface terminated with oxygen and a hydroxyl group is covered with a resin film.

7. A method of fabricating a mold (101) for nano-imprint, comprising the steps of: acid-treating a nano-imprint side surface having a surface formed from Ni or Ni alloy to form a Ni-containing oxide film (103) with a thickness of 1 to 3 nm.

8. The method of fabricating a mold (101) for nano-imprint according to claim 7, wherein a resin film (104) is formed on the surface of the acid-treated Ni-containing oxide film (103).

9. The method of fabricating a mold (101) for nano-imprint according to claim 7 or 8, wherein a contact angle between the Ni-containing oxide film and water is 100 degrees or more.

10. An imprint equipment, comprising:
means for supporting a resin film in which nano meter level convexo-concaves are to be formed;
a mold (16) for nano-imprint having a nano-imprint face; and
a stage (14) which supports the mold for nano-imprint as to face to the resin film surface,
wherein at least the nano-imprint face of the mold for nano-imprint is formed from Ni or Ni alloy, and the nano-imprint face has a Ni-containing oxide film with a thickness of 1 to 3 nm and a water repellent resin film covering the surface thereof.

11. A nano-imprint method, comprising the steps of:
bringing an imprint face of a mold (16) made of Ni or Ni alloy, the mold (16) having a Ni-containing oxide film with a thickness of 1 to 3 nm and a water-repellent resin film covering the surface thereof, in contact with an organic resin film face, in which nano meter level convexo-concaves are to be formed;
controlling a softening and hardening of the organic resin film with heat, light, and/or a carbon dioxide gas; and
transferring the convexo-concaves of the mold for nano-imprint onto the organic resin film face.

12. The nano-imprint method according to claim 11, wherein the contact angle between the Ni-containing oxide film and water is 100 degrees or more.

13. The nano-imprint method according to claim 11, wherein the contact angle between the resin film and water is 100 degrees or more.
